# EUROPEAN PATENT SPECIFICATION

(11) **EP 1 362 395 B1**
(45) Date of publication and mention of the grant of the patent: **13.04.2005**
(21) Application number: 02700475.3
(22) Date of filing: 15.02.2002
(51) Int. Cl.: H01S 5/10, H01S 5/12, H01S 5/34, H01L 33/00

(54) **SEMICONDUCTOR LASER COMPRISING A PLURALITY OF OPTICALLY ACTIVE REGIONS**
HALBLEITERLASER MIT EINER VIELZAHL VON OPTISCH AKTIVEN GEBIETEN
LASER A SEMI-CONDUCTEURS COMPRENANT UNE PLURALITE DE REGIONS OPTIQUEMENT ACTIVES

(30) Priority: 16.02.2001 GB 0103838
(43) Date of publication of application: 19.11.2003
(73) Proprietor: The University Court of the University of Glasgow, Glasgow G12 8QQ (GB)
(72) Inventor: MARSH, John, Haig, Glasgow G12 0SN (GB); KIM, Shin-Sung, Glasgow G13 4TA (GB)
(74) Representative: Charig, Raymond Julian
(86) International application number: PCT/GB2002/000808
(87) International publication number: WO 2002/067392

(56) References cited:
- US-A- 4 720 836
- US-A- 4 751 194
- US-A- 5 657 157
- GETTY J T ET AL: "Monolithic series-connected 1.55 µm segmented-ridge lasers" ELECTRONICS LETTERS, IEE STEVENAGE, GB, vol. 35, no. 15, 22 July 1999 (1999-07-22), pages 1257-1258, XP006012450 ISSN: 0013-5194
- PATENT ABSTRACTS OF JAPAN vol. 013, no. 086 (E-720), 28 February 1989 (1989-02-28) -& JP 63 263788 A (MITSUBISHI ELECTRIC CORP), 31 October 1988 (1988-10-31)
- HAMILTON C J ET AL: "HIGH-POWER AND HIGH-BRIGHTNESS VISIBLE SEMICONDUCTORLASER DIODES" PROCEEDINGS OF THE SPIE, SPIE, BELLINGHAM, VA, US, vol. 3947, 24 January 2000 (2000-01-24), pages 91-97, XP001050420
- PATENT ABSTRACTS OF JAPAN vol. 011, no. 059 (E-482), 24 February 1987 (1987-02-24) -& JP 61 218190 A (AGENCY OF IND SCIENCE & TECHNOL), 27 September 1986 (1986-09-27)
- KIM ET AL.: "Segmented gain-section AlGaInP laser" CONFERENCE ON LASERS AND ELECTRO-OPTICS EUROPE (CLEO), TECHNICAL DIGEST, BALTIMORE, MD USA , 6 - 11 May 2001, page 81 XP002195985

## Description

### FIELD OF INVENTION

The present invention relates to semiconductor laser devices, and in particular, though not exclusively, to a broad area semiconductor laser with a single-lobed far field pattern.

The present application is related to pending Application Number GB 01 01 641.9 of 23 January 2001, also by the same Applicant and entitled "Improvements in or Relating to Semiconductor Lasers".

### BACKGROUND TO INVENTION

Broad area lasers are used for high power applications, but suffer from a number of problems such as filamentation, instabilities in the transverse mode, and poor far-field characteristics. A reason for filament formation is related to the self-focusing nonlinear behaviour that occurs in the gain section of a broad stripe semiconductor laser.

An object of the present invention is to obviate or mitigate the aforementioned problems in the prior art.

A further object of the present invention is to provide a broad area semiconductor laser that exhibits a high power output power without sacrificing the transverse beam quality. J T Getty *et al*: "Monolithic series-connected 1.55 micron segmented-ridge lasers"; Electronic Letters Vol 35 No 15, July 1999 describes formation of a set of series connected, narrow (1.55 micron) waveguide, segmented ridge lasers using ion implantation-enhanced quantum well disordering to form isolation sections. US 5657157 describes a semiconductor optical amplifier having alternating non-linear optical regions of positive and negative self-focussing.

### SUMMARY OF INVENTION

According to the present invention, there is provided a semiconductor broad area laser device comprising a plurality of optically active regions and a plurality of optically passive regions arranged in substantially linear relation along the optical axis of the laser, each optically active region including a quantum well structure, adjacent optically active regions being spaced from one another by a respective quantum well intermixed (QWI) optically passive region, each optically passive region forming a diffraction region that acts as a spatial mode filter to selectively cause substantially single transverse mode output by diffraction losses to higher order modes.

The spacing between adjacent optically active regions may conveniently be termed "segmentation".

Preferably each optically active region is operatively associated with a respective current injection region.

Preferably the current injection regions are arranged in substantially linear relation one to the other, upon a surface of the device.

Preferably the current injection regions are substantially equally spaced one from the next.

Preferably first and last of the current injection regions are each spaced from first and second ends of the device.

Preferably, the optically active regions are provided in an active layer comprising an active lasing material including a Quantum Well (QW) structure, as grown.

Preferably, the Quantum Well structure is retained within areas of the optically active layer corresponding to current injection regions, while areas of the optically active layer between current injection regions are Quantum Well Intermixed (QWI).

Preferably also, areas of the optically active layer between the first of the plurality of current injection regions and the first end of the device and between the last of the plurality of current injection regions and the second end of the device are Quantum Well Intermixed (QWI).

Preferably also, areas of the optically active layer bounding the plurality of current injection regions are Quantum Well Intermixed (QWI).

Preferably the optically active and passive regions are provided within a core or guiding layer between first (lower) and second (upper) optical cladding/charge carrier confining layers, which guiding layer may comprise an active lasing material.

Preferably a ridge is formed in at least the second cladding layer and extends longitudinally from the first end of the device to the second end of the device.

The QWI regions may have a larger band-gap than the active region.

The QWI regions may therefore have a lower optical absorption than the active regions.

Preferably the device may be of a monolithic construction.

More preferably the device may include a substrate layer upon which may be provided the first cladding layer, core layer, and second cladding layer respectively.

Preferably one end or facet of the device may comprise an output of the semiconductor laser device.

The QWI washes out the Quantum Well Intermixing (QWI) confinement of the wells within the core layer. More preferably, the QWI may be substantially impurity free. The QWI regions may be "blue-shifted", that is, typically greater than 20 - 30 meV, and more typically, a 100meV or more difference band-gap energy exists between the optical active region when pumped with carriers and the QWI passive regions. The optically passive regions, therefore, act as a spatial mode filter as higher order modes will experience greater diffraction losses as they propagate through the first compositionally disordered lasing material than the fundamental mode. Thus the fundamental mode will have a greater overlap with the active region and be selectively amplified. The semiconductor laser device may, therefore, be adapted to provide a substantially single mode output.

Preferably the semiconductor laser device further comprises respective layers of contact material (metalisations) contacting a portion of a surface of the device corresponding to the current injection regions and an opposing surface of the substrate. The contact layers may provide for drive current to the optical active or "gain" regions.

Preferably the semiconductor laser device is fabricated in a III - V materials system such as Gallium Arsenide (GaAs) or as Aluminium Gallium Arsenide (AlGaAs) or Aluminium Gallium Indium Phosphide (AlGaInP), and may therefore lase at a wavelength of substantially between 600 and 1300 nm. The first and second compositionally disordered materials may substantially comprise Indium Gallium Arsenide (InGaAs). It will, however, be appreciated that other material systems may be employed, eg Indium Phosphide (InP), and may therefore lase at a wavelength of substantially between 1200 and 1700 nm.

Also described herein is a method for fabricating a semiconductor laser device according to the aforementioned aspect comprising the steps of:
(i) forming in order:
   a first optical cladding/charge carrier
   confining layer;
   a core (lasing material) layer, in which is formed a Quantum Well Intermixed (QWI) structure; and
   a second optical cladding/charge carrier confining layer;
(ii) forming passive regions in the core layer.
   The method may also include the step of:
(iii) forming a ridge from at least a portion of the second cladding layer.

Step (i) may be carried out by known growth techniques such as Molecular Beam Epitaxy (MBE) Epitaxy (MBE) or Metal Organic Chemical Vapour Deposition (MOCVD).

Steps (ii) and (iii) may be interchanged, though it is preferred to carry out step (ii) then step (iii).

Preferably the passive region(s) may be formed by a Quantum Well Intermixing (QWI) technique which may preferably comprise generating vacancies in the passive region(s), or may alternatively comprise implanting or diffusing ions into the passive region(s), and annealing to create a compositionally disordered region(s) of the core layer, having a larger band-gap than the Quantum Well Intermixed (QW) structure.

Preferably the QWI technique may be performed by generating impurity free vacancies, and more preferably may use a damage induced technique to achieve Quantum Well Intermixing (QWI). In a preferred implementation of such a technique, the method may include the steps of:
depositing by use of a diode sputterer and within a substantially Argon atmosphere a dielectric layer such as Silica (SiO₂) on at least part of a surface of the semiconductor laser device material so as to introduce point structural defects at least into a portion of the material adjacent the dielectric layer;
optionally depositing by a non-sputtering technique such as Plasma Enhanced Chemical Vapour Deposition (PECVD) a further dielectric layer on at least another part of the surface of the material;
annealing the material thereby transferring ions or atoms from the material into the dielectric layer. Such a technique is described in co-pending Application Number GB 01 01 635.1 entitled "Method of Manufacturing Optical Devices and Related Improvements" also by the present Applicant, and having a filing date of 23 January 2001 the content of which is incorporated herein by reference.

Preferably in step (ii) the passive region may be formed by QWI into the region to create compositionally disordered regions of the lasing material having a larger band-gap than the Quantum Well (QW) structure.

Preferably step (iii) may be achieved by known etching techniques, eg dry or wet etching.

Preferably the method may include the step of initially providing a substrate onto which is grown the first cladding layer, core layer, and second cladding layer, respectively.

Preferably, step (ii) may be performed by generating impurity free vacancies, and more preferably may use a damage enhanced technique to achieve Quantum Well Intermixing (QWI).

The plurality of optically active regions may comprise a gain section a width of which may vary along a length of the device, eg the width thereof may taper or flare towards an output end of the device.

Spacing between one optically active region and a next optically active region and between the next optically active region and a yet next optically active region may be substantially the same or may be of variable period or non-periodic.

### BRIEF DESCRIPTION OF DRAWINGS

An embodiment of the present invention will now be described, by way of example only, and with reference to the accompanying drawings, which are:
- **Figure 1**: a simplified schematic perspective view from one side to one end and above of a semiconductor laser device according to a first embodiment of the present invention;
- **Figure 2**: a plan view of the semiconductor laser device of Figure 1;
- **Figure 3**: photo-luminescence spectra for non Quantum Well Intermixed (QWI) and QWI regions of a device according to a second embodiment of the present invention; and
- **Figure 4**: a graph of optical output power against current for the device of Figure 3.

### DETAILED DESCRIPTION OF DRAWINGS

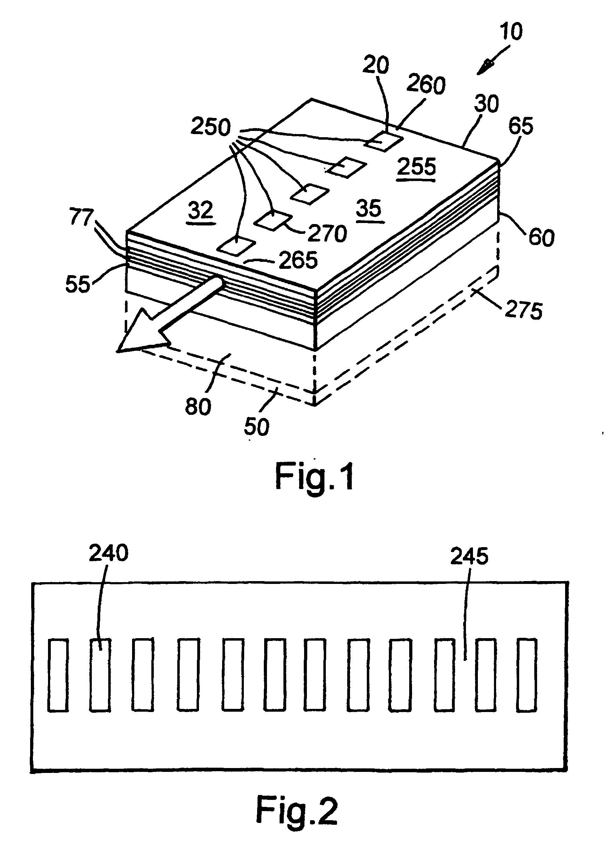

Referring initially to Figures 1 and 2, there is shown a semiconductor laser device, generally designated 10, according to an embodiment of the present invention.

The semiconductor laser device 10 comprises; a plurality of optically active regions 240, each optically active region 240 including a Quantum Well (QW) structure 77; adjacently optically active regions 240 being spaced by a respective optically passive region 245, each optically passive region 245 being Quantum Well Intermixed (QWI). The spacing between adjacent optically active regions 240 is conveniently termed "segmentation".

As can be seen from Figures 1 and 2, each optically active region 240 is operatively associated with a respective current injection region 250. The current injection regions 250 are arranged in substantially linear relation, one to the other, on a surface 255 of the device 10. In this embodiment the current injection regions 250 are substantially equally spaced one from the next.

Further, first and last of the current injection regions 250 are each spaced from a first and a second end 30,50 of the device 10 respectively.

The optically active regions 240 are provided within an active core layer 55 comprising an active lasing material including a Quantum Well (QW) structure 77, as grown. The Quantum Well (QW) structure 77 is retained in the areas of the optically active layer 55 corresponding to current injection regions 250, while areas of the optically active layer 55 between current injection regions 240 are Quantum Well Intermixed (QWI).

Further, areas 260,265 between the first of the plurality of current injection regions 250 and the first end 30 of the device 10 and between the last of the plurality of current injection regions 250 and the second end 50 of the device 10 respectively, are Quantum Well Intermixed (QWI).

Further, areas 32,35 of the optically active layer 55 laterally bounding the plurality of current injection regions 250 are also Quantum Well Intermixed (QWI).

The optically active and passive regions 240,245 are provided within the core or guiding layer 55 provided between first and second optical cladding layers 60,65, the guiding layer 55 comprising an active lasing material.

In a modification a ridge waveguide may be formed in at least the second cladding layer 65, which ridge extends longitudinally from the first end 30 of the device 10 to the second end 50 of the device 10, or at least part way therebetween, and indeed may itself be segmented.

It will be appreciated that the QWI regions will have a larger band-gap than the active regions. The QWI regions will therefore also have a lower absorption than the active regions.

Device 10 of Figure 1 is of a substantially monolithic construction, the device 10 being formed on a substrate 80 on which are grown the first cladding layer 60, core layer 55, and second cladding layer 65 respectively.

In this embodiment the second end 50 of the device 10 comprises an output of the semiconductor laser device 10.

The semiconductor laser device 10 further comprises contact materials (metalisations) 270,275, contacting respectively portions of surface 255 of laser device 10 corresponding to current injection regions 250, and an opposing surface of the substrate 80. Contact layers 270,275 therefore provide for drive current to the optically active or gain regions 240, in use.

In a modification, the plurality of optically active regions 240 comprise a gain section of the device 10, and a width of the gain section varies along a length of the device 10. The width may be varied by varying the width of adjacent contacts 270, and may taper or flare towards an output end of the device 10.

In a further modification spacing between one optically active region 240 and a next optically active region 240 and spacing between the next optically active region and a next optically active region is substantially the same or of variable period or non-periodic.

In this embodiment the semiconductor laser device 10 is fabricated in III-V semiconductor materials system comprising Aluminium Gallium Indium Phosphide (AlGaInP), and may therefore operate in the wavelength region 610 to 700nm. It will, however, be appreciated that in other embodiments other III-V semiconductor material systems may be used in fabrication of the device.

The device 10 is fabricated according to the following method steps:
(i) forming in order the first optical cladding layer 60 on substrate 80, forming core layer 55 on first optical cladding layer 60, the core layer 15 being provided with a Quantum Well (QW) structure 77, and forming second optical cladding layer 65 on core layer 55, and
(ii) forming the passive regions 245 in the core layer 55.

Step (i) is conveniently carried out by known growth techniques, particularly, for example, Molecular Beam Epitaxy (MBE) or Metal Organic Chemical Vapour Deposition (MOCVD).

In this embodiment the passive regions 245 are formed by a Quantum Well Intermixing (QWI) technique comprising generating impurity free vacancies. The preferred implementation of the QWI technique comprises the following steps:
depositing by use of a diode sputterer and within an Argon atmosphere, a dielectric layer such as Silica (SiO₂) on at least part of the surface 255 of semiconductor laser device 10, so as to introduce point structural defects at least into a portion of the material adjacent to dielectric layer;
optionally depositing by a non-sputtering technique - such as Plasma Enhanced Chemical Vapour Deposition (PECVD) a further dielectric layer in at least part of the surface of the device 10;
annealing the device 10 thereby transferring Gallium ions or atoms from the device material into the dielectric layer.

It will be appreciated that the active core layer 55, first cladding layer 60, and second cladding layer 65, will each have a refractive index of around 3.0 to 3.5, the core layer 55 having a higher refractive index than the cladding layer 60,65.

### EXAMPLE

As an example of improved device performance, a second embodiment of a segmented gain section laser device according to the present invention fabricated in the InGaAsP/GaAs material system will now be given.

The wafer structure used was a 670nm double Quantum Well (QW) laser layer, grown on a (100) Si doped GaAs substrate misoriented 10° to the (111)A direction. The misoriented wafer ensured that ordering of the AlGaInP quaternary was minimised securing good laser performance. The epitaxial layer structure is listed in Table 1. The lasing spectrum was centred on 676nm with a turn on voltage of 1.987V. A typical threshold current density for infinite cavity length was 330A cm⁻².

**TABLE 1**

| **Material** | **Thickness** | **Purpose** | **Dopant** | **Carrier concentration (cm**⁻³) | **Layer Number** |
|---|---|---|---|---|---|
| GaAs | 300nm | Cap | Zn | 8x10¹⁸ | --- |
| Ga_{0.5}In_{0.5}P | 20nm | Grading Layer | Zn | 2x10¹⁸ | --- |
| (Al_{0.7}Ga_{0.3})_{0.5} In_{0.5}P | 1000nm | Upper cladding | Zn | 8x10¹⁷ | 65 |
| (Al_{0.3}Ga_{0.7})_{0.5} In_{0.5}P | 300nm | Waveguide Core | Undoped | | 55 |
| Ga_{0.41}In_{0.50}P | 6.5nm | QW | Undoped | | 55 |
| (Al_{0.3}Ga_{0.7})_{0.5} In_{0.5}P | 15nm | Central barrier | Undoped | | 55 |
| Ga_{0.41}In_{0.53}P | 6.5nm | QW | Undoped | | 55 |
| (Al_{0.3}Ga_{0.7})_{0.5} In_{0.5}P | 300nm | Waveguide core | Undoped | | 55 |
| In_{0.5}P | 1000nm | Lower cladding | Si | 8x10¹⁷ | 60 |
| GaAs | 500nm | Buffer | Si | 3x10¹⁸ | --- |
| GaAs | | Substrate | Si | 2x10¹⁸ | 80 |

The fabrication procedural steps are as follows:
(a) photoresist patterning for Quantum Well Intermixing (QWI);
(b) Silica sputtering;
(c) Silica lift-off;
(d) E-beam evaporation of Silica;
(e) rapid thermal annealing;
(f) removal of Silica;
(g) photoresist patterning for p-contact;
(h) E-beam evaporation of Silica;
(i) Silica lift-off;
(j) p-contact metalisation;
(k) thinning;
(l) n-contact metalisation;

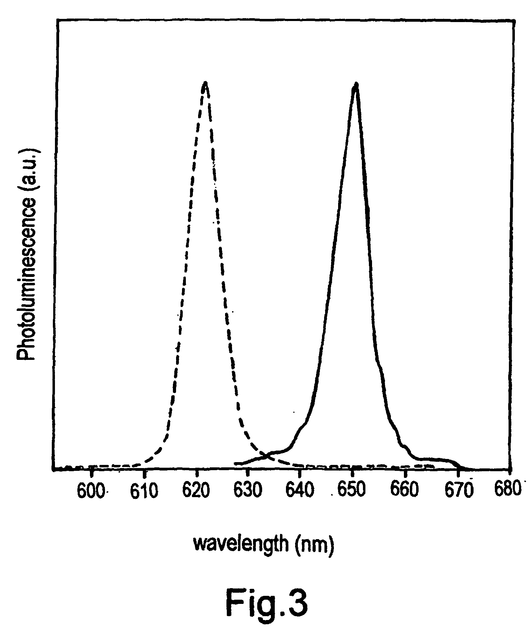

The QWI process involves sputtering 20nm of SiO₂ followed by a rapid thermal anneal at 750°C for 30seconds. Suppression of the intermixing process can be achieved by protecting the active regions during the sputtering stage with photoresist. The resist and the overlying layers were then removed by lift-off in acetone, and the entire sample was coated with a 200nm layer of SiO₂ by electron beam evaporation, to protect the exposed regions during the ensuing anneal. After annealing, 77K photo-luminescence measurements were used to determine the resultant band-gap shift in the passive regions, in this case 30nm, as shown in Figure 3.

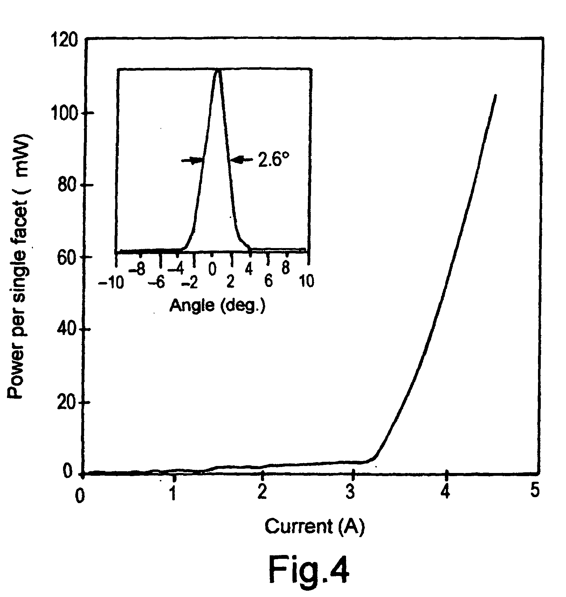

Figure 4 shows the light current characteristics of the device with an 80 µm aperture, 1500 µm length, 100 µm period and 40 µm of gain-section and 60 µm of diffractive section in each period. A pulsed output power of 200 mW was measured at 4.5A. The inset in Figure 4 shows the lateral far-field distribution, which approximates to a Gaussian profile. For all power levels, the far-field angle remained constant at 2.6° (approximately 4 x the diffraction limit, but with no correcting lens). It is anticipated that further optimisation of the device design, period of segmentation including the possible use of variable period and non-periodic segmentation, and of processing conditions will enable the threshold current to be reduced and the power output to be increased.

It will be appreciated that the embodiments of the invention hereinbefore described are given by way of example only, and are not intended to limit the scope thereof in any way.

For example, it will be appreciated that the gain sections may be index guided by various waveguiding means such as a ridge or a buried heterostructure waveguide, or an Anti Resonant Reflecting Optical Waveguide (ARROW).

Further, it will be understood that in this invention, Quantum Well Intermixing (QWI) technologies are used to create band-gap widened passive waveguide sections along the length of the device. The invention relates to all compound semiconductor laser structures containing Quantum Well (QW) in which the Quantum Well Intermixing (QWI) profile can be modified using Quantum Well Intermixing (QWI). Advantages of Quantum Well Intermixing (QWI) in this invention include:
alignment of active and passive waveguides;
simple fabrication procedure;
negligible reflection coefficient at active/passive interfaces.

Finally, it will be appreciated that a semiconductor laser device according to the present invention may incorporate gratings, if desired.

## Claims

1. A semiconductor broad area laser device (10) comprising a plurality of optically active regions (240) and a plurality of optically passive regions (245) arranged in substantially linear relation along the optical axis of the laser,
each optically active region including a quantum well structure (77), adjacent optically active regions (240) being spaced from one another by a respective quantum well intermixed optically passive region (245),
each optically passive region (245) forming a diffraction region that acts as a spatial mode filter to selectively cause substantially single transverse mode output by diffraction losses to higher order modes.

2. A semiconductor laser device as claimed in claim 1, wherein each optically active region (240) is operatively associated with a respective current injection region (250).

3. A semiconductor laser device as claimed in claim 2, wherein the current injection regions (250) are arranged in substantially linear relation one to the other, upon a surface (255) of the device.

4. A semiconductor laser device as claimed in claim 2 or claim 3, wherein the current injection regions (250) are substantially equally spaced one from the next.

5. A semiconductor laser device as claimed in either of claims 3 or 4, wherein first and last of the current injection regions (250) are each spaced from first and second ends (30,40) of the device.

6. A semiconductor laser device as claimed in claim 2, wherein the optically active regions (240) are provided in an optically active layer (55) comprising an active lasing material including a Quantum Well structure (77), as grown.

7. A semiconductor laser device as claimed in claim 6, wherein the Quantum Well structure (77) is retained within areas of the optically active layer corresponding to current injection regions, while areas of the optically active layer between current injection regions are Quantum Well Intermixed.

8. A semiconductor laser device as claimed in claims 6 or 7, wherein areas (260) of the optically active layer (55) between the first of the plurality of current injection regions (250) and the first end (30) of the device and between the last of the plurality of current injection regions (250) and the second end (40) of the device are Quantum Well Intermixed.

9. A semiconductor laser device as claimed in either of claims 7 or 8, wherein areas (32,35) of the optically active layer bounding the plurality of current injection regions (250) are Quantum Well Intermixed.

10. A semiconductor laser device as claimed in any of claims 1 to 9, wherein the optically active and optically passive regions (240,245) are provided within an optical guiding layer (55) between first and second optical cladding layers (60,65).

11. A semiconductor laser device as claimed in claim 6, wherein a ridge is formed in at least the second cladding layer and extends longitudinally from the first end of the device to the second end of the device.

12. A semiconductor laser device as claimed in any preceding claim, wherein the Quantun Well Intermixed regions (245) have a larger band-gap than the optically active regions (240).

13. A semiconductor laser device as claimed in any preceding claim, wherein the device (10) is of a monolithic construction, the device including a substrate layer (80) upon which is provided the first cladding layer (60), core layer (55), and second cladding layer (65) respectively.

14. A semiconductor laser device as claimed in any preceding claim, wherein the semiconductor laser device is fabricated in a III - V materials system.

15. A semiconductor laser device as claimed in claim 14, wherein the III-V materials system is selected from Gallium Arsenide (GaAs), Aluminium Gallium Arsenide (AlGaAs), Aluminium Gallium Indium Phosphide (AlGaInP), or Indium Phosphide (InP).

16. A semiconductor laser device as claimed in claim 14, wherein the first and second compositionally disordered materials substantially comprise Indium Gallium Arsenide (InGaAs).

## Patentansprüche

1. Halbleiter-Breitstreifenlasergerät (10), das eine Vielzahl optisch aktiver Gebiete (240) und eine Vielzahl optisch passiver Gebiete (245) umfasst, die in im Wesentlichen linearer Beziehung entlang der optischen Achse des Lasers angeordnet sind,
wobei jedes optisch aktive Gebiet eine Quantenfilm-Struktur (77) beinhaltet, wobei benachbarte optisch aktive Gebiete (240) durch ein entsprechendes Quantenfilm-durchmischtes optisch passives Gebiet (245) mit Abstand voneinander angeordnet sind,
wobei jedes optisch passive Gebiet (245) ein Beugungsgebiet bildet, das als Raummodenfilter agiert, um selektiv durch Beugungsverluste von Moden höherer Ordnung im Wesentlichen den Ausgang einfach transversaler Moden zu verursachen.

2. Halbleiterlasergerät nach Anspruch 1, wobei jedes optisch aktive Gebiet (240) operativ einem entsprechenden Strominjektionsgebiet (250) zugeordnet ist.

3. Halbleiterlasergerät nach Anspruch 2, wobei die Strominjektionsgebiete (250) zueinander in im Wesentlichen linearer Beziehung auf einer Oberfläche (255) des Gerätes angeordnet sind.

4. Halbleiterlasergerät nach Anspruch 2 oder Anspruch 3, wobei die Strominjektionsgebiete (250) in im Wesentlichen gleichen Abstand zum jeweils nächsten angeordnet.

5. Halbleiterlasergerät nach einem der Ansprüche 3 oder 4, wobei das Erste und Letzte der Strominjektionsgebiete (250) jeweils mit Abstand zu ersten und zweiten Enden (30,40) des Gerätes angeordnet sind.

6. Halbleiterlasergerät nach Anspruch 2, wobei die optisch aktiven Gebiete (240) in einer optisch aktiven Schicht (55) bereitgestellt sind, die ein aktives Laser-Material umfasst, das eine Quantenfilm- (QW-) -Struktur (77) beinhaltet, wie gewachsen.

7. Halbleiterlasergerät nach Anspruch 6, wobei die Quantenfilm-Struktur (77) innerhalb von Bereichen der optisch aktiven Schicht gehalten ist, die Strominjektionsgebieten entsprechen, während Bereiche der optisch aktiven Schicht zwischen Strominjektionsgebieten Quantenfilm-durchmischt sind.

8. Halbleiterlasergerät nach Anspruch 6 oder 7, wobei Bereiche (260) der optisch aktiven Schicht (55) zwischen dem Ersten der Vielzahl von Strominjektionsgebieten (250) und dem ersten Ende (30) des Gerätes und zwischen dem Letzten der Vielzahl von Strominjektionsgebieten (250) und dem zweiten Ende (40) des Gerätes Quantenfilm-durchmischt sind.

9. Halbleiterlasergerät nach seinem der Ansprüche 7 oder 8, wobei Bereiche (32,35) der optisch aktiven Schicht Quantenfilm-durchmischt sind, die die Vielzahl von Strominjektionsgebieten (250) abgrenzen.

10. Halbleiterlasergerät nach einem der Ansprüche 1 bis 9, wobei die optisch aktiven und optisch passiven Gebiete (240,245) innerhalb einer optischen Leiterschicht (55) zwischen ersten und zweiten optischen Beschichtungschichten (60,65) bereitgestellt sind.

11. Halbleiterlasergerät nach Anspruch 6, wobei eine Rippe in mindestens der zweiten Beschichtungsschicht gebildet ist und sich längs vom ersten Ende des Gerätes zum zweiten Ende des Gerätes erstreckt.

12. Halbleiterlasergerät nach einem der vorhergehenden Ansprüche, wobei die Quantenfilm-durchmischten Gebiete (245) eine größere Bandlücke als die optisch aktiven Gebiete (240) aufweisen.

13. Halbleiterlasergerät nach einem der vorhergehenden Ansprüche, wobei das Gerät (10) von monolithischem Aufbau ist, wobei das Gerät eine Substratschicht (80) beinhaltet, auf der die erste Beschichtungsschicht (60), Kernschicht (55) bzw. zweite Beschichtungsschicht (65) bereitgestellt ist.

14. Halbleiterlasergerät nach einem der vorhergehenden Ansprüche, wobei das Halbleiterlasergerät in einem III-V-Werkstoffsystem gefertigt ist.

15. Halbleiterlasergerät nach Anspruch 14, wobei das III-V-Werkstoffsystem aus Galliumarsenid (GaAs), Aluminium-Galliumarsenid (AlGaAs), Aluminium-Gallium-Indiumphosphid (AlGalnP) oder Indiumphosphid (InP) ausgewählt ist.

16. Halbleiterlasergerät nach Anspruch 14, wobei die ersten und zweiten zusammensetzungsmäßig ungeordneten Werkstoffe im Wesentlichen Indium-Galliumarsenid (InGaAs) umfassen.

## Revendications

1. Dispositif à laser à semi-conducteur de grande superficie (10) comprenant une pluralité de régions opto-actives (240) et une pluralité de régions opto-passives (245) agencées selon une relation sensiblement linéaire le long de l'axe optique du laser,
chaque région opto-active comportant une structure de puits quantique (77), les régions opto-actives adjacentes (240) étant espacées les unes des autres par une région opto-passive respective (245) à puits quantiques mutuellement mélangés,
chaque région opto-passive (245) formant une région de diffraction qui joue le rôle de filtre de mode spatial pour provoquer sélectivement la sortie d'un mode transverse sensiblement unique par les pertes de diffraction sous forme de modes d'ordre supérieur.

2. Dispositif à laser à semi-conducteur selon la revendication 1, dans lequel chaque région opto-active (240) est fonctionnellement associée à une région d'injection de courant respective (250).

3. Dispositif à laser à semi-conducteur selon la revendication 2, dans lequel les régions d'injection de courant (250) sont agencées de façon sensiblement linéaire l'une par rapport à l'autre sur une surface (255) du dispositif.

4. Dispositif à laser à semi-conducteur selon la revendication 2 ou 3, dans lequel les régions d'injection de courant (250) sont sensiblement régulièrement espacées les unes des autres.

5. Dispositif à laser à semi-conducteur selon l'une ou l'autre des revendications 3 et 4, dans lequel les première et dernière régions d'injection de courant (250) sont chacune espacées des première et seconde extrémités (30, 40) du dispositif.

6. Dispositif à laser à semi-conducteur selon la revendication 2, dans lequel les régions opto-actives (240) sont disposées dans une couche opto-active (55) comprenant un matériau d'émission laser actif comportant une structure de Puits Quantique (77) tel qu'obtenu après croissance.

7. Dispositif à laser à semi-conducteur selon la revendication 6, dans lequel la structure à Puits Quantique (77) est retenue dans des zones de la couche opto-active qui correspondent à des régions d'injection de courant, tandis que les zones de la couche opto-active entre les régions d'injection de courant sont à Puits Quantiques Mutuellement Mélangés.

8. Dispositif à laser à semi-conducteur selon la revendication 6 ou 7, dans lequel des zones (260) de la couche opto-active (55) entre la première de la pluralité de régions d'injection de courant (250) et la première extrémité (30) du dispositif et entre la dernière de la pluralité de régions d'injection de courant (250) et la seconde extrémité (40) du dispositif sont à Puits Quantiques Mutuellement Mélangés.

9. Dispositif à laser à semi-conducteur selon l'une ou l'autre des revendications 7 et 8, dans lequel des zones (32, 35) de la couche opto-active délimitant la pluralité de régions d'injection de courant (250) sont à Puits Quantiques Mutuellement Mélangés.

10. Dispositif à laser à semi-conducteur selon l'une quelconque des revendications 1 à 9, dans lequel les régions opto-actives et opto-passives (240, 245) sont disposées dans une couche de guidage optique (55) entre des première et seconde couches de gainage optiques (60, 65).

11. Dispositif à laser à semi-conducteur selon la revendication 6, dans lequel une saillie est formée dans au moins la seconde couche de gainage et s'étend longitudinalement depuis la première extrémité du dispositif vers la seconde extrémité du dispositif.

12. Dispositif à laser à semi-conducteur selon l'une quelconque des revendications précédentes, dans lequel les régions à Puits Quantiques Mutuellement Mélangés (245) ont une bande interdite plus grande que les régions opto-actives (240).

13. Dispositif à laser à semi-conducteur selon l'une quelconque des revendications précédentes, dans lequel le dispositif (10) est de structure monolithique, le dispositif comportant une couche de substrat (80) sur laquelle sont respectivement disposées la première couche de gainage (60), une couche de coeur (55) et une seconde couche de gainage (65).

14. Dispositif à laser à semi-conducteur selon l'une quelconque des revendications précédentes, dans lequel le dispositif à laser à semi-conducteur est fabriqué à partir d'un système de matériaux des groupes III-V.

15. Dispositif à laser à semi-conducteur selon la revendication 14, dans lequel le système de matériaux des groupes III-V est sélectionné parmi l'arséniure de Gallium (GaAs), l'arséniure de Gallium dopé à l'aluminium (AlGaAs), le phosphure de Gallium et d'Indium dopé à l'aluminium (AlGaInP) ou le phosphure d'Indium (InP).

16. Dispositif à laser à semi-conducteur selon la revendication 14, dans lequel les premier et second matériaux désordonnés du point de vue de la composition comprennent en substance l'arséniure d'Indium et de Gallium (InGaAs).
